# EUROPÄISCHE PATENTANMELDUNG

(11) **EP 0 825 448 A2**
(43) Veröffentlichungstag der Anmeldung: **25.02.1998**
(21) Anmeldenummer: 97810522.9
(22) Anmeldetag: 23.07.1997
(51) Int. Cl.: G01R 15/14

(54) **Messvorrichtung für eine metallgekapselte gasisolierte Hochspannungsanlage**

(30) Priorität: 23.08.1996 DE 19633989
(71) Anmelder: Asea Brown Boveri AG, 5401 Baden (CH)
(72) Erfinder: Füglister, Marcel, 5272 Gansingen (CH); Jaussi, Alfred Walter, 8032 Zürich (CH); Kaczkowski, Andrzej, Dr., 5403 Würenlingen (CH); Meng, Markus, 5423 Freienwil (CH)
(74) Vertreter: Kaiser, Helmut

(57) **Zusammenfassung**

Die Messvorrichtung ist für eine metallgekapselte, gasisolierte Hochspannungsanlage bestimmt. Sie enthält mindestens einen in einem isoliergasgefüllten Kapselungsrohr (3) der Metallkapselung angeordneten Sensor (10, 11) und mindestens eine Ausgangssignale des Sensors (10, 11) verarbeitende elektronische Auswertevorrichtung (23, 23'). Die Auswertevorrichtung (23, 23') und eine die Auswertevorrichtung mit einem Ausgang des Sensors (10, 11) verbindende Steckvorrichtung (28, 28') sind in einem zweiteilig ausgeführten Metallgehäuse angeordnet. Ein Teil diese Gehäuses wird von einem an die Aussenfläche des Kapselungsrohrs (3) angeformten metallenen Hohlflansch (26) und dem vom Hohlflansch (26) umrandeten Bereich des Kapselungsrohrs (3) gebildet. Das andere Teil des Gehäuses ist ein trogförmig vertieftes Gehäuseelement (27), welches mit seinem die Trogöffnung begrenzenden Rand am metallenen Hohlflansch (27) des Kapselungsrohrs (3) befestigt ist.

Diese Messvorrichtung zeichnet durch einen kompakten Aufbau und wegen der Prozessnähe durch eine hohe Messgenauigkeit und eine grosse Betriebssicherheit aus.

## Beschreibung

### TECHNISCHES GEBIET

Bei der Erfindung wird ausgegangen von einer Messvorrichtung für eine metallgekapselte, gasisolierte Hochspannungsanlage nach dem Oberbegriff von Patentanspruch 1. Eine derartige Messvorrichtung enthält mindestens einen in einem isoliergasgefüllten Kapselungsrohr der Metallkapselung angeordneten Sensor und eine Ausgangssignale des mindestens einen Sensors verarbeitende elektronische Auswertevorrichtung. Die Messvorrichtung dient vor allem der Messung eines in einem Innenleiter der Hochspannungsanlage geführten Stroms und/oder der Messung der Spannung dieses Innenleiters, kann aber auch zur Messung anderer physikalischer Grössen der Anlage, wie etwa zur Messung des Drucks, der Temperatur und/oder der Dichte des Isoliergases oder für Teilentladungsmessungen, verwendet werden.

### STAND DER TECHNIK

Die Erfindung nimmt dabei Bezug auf einen Stand der Technik von Messvorrichtungen für metallgekapselte, gasisolierte Hochspannungsanlagen wie er etwa aus EP 0 510 311 A2 bekannt ist. Ein in diesem Stand der Technik beschriebener kombinierter Strom- und Spannungswandler für eine metallgekapselte, gasisolierte Hochspannungsanlage enthält im Inneren eines isoliergasgefüllten Kapselungsrohrs der Metallkapselung eine um einen stromführenden Leiter geführte und der Messung des Leiterstromes dienende Rogowskispule sowie eine konzentrisch zum Leiter in elektrisch isolierender Weise angeordnete rohrförmige Metallelektrode, welcher der Messung der Leiterspannung dient. Von der Rogowskispule und der Messelektrode abgebene Ausgangssignale werden in abgeschirmten Leitungen durch die Wand des Kapselungsrohrs zu einer von der Metallkapselung entfernt liegenden Auswerteelektronik geführt, in der aus den Ausgangssignalen Messwerte gebildet werden, die dem im Stromleiter führenden Strom bzw. der am Stromleiter anliegenden Spannung entsprechen. Hierbei sind jedoch umgebungsbedingte Veränderungen oder Störungen der Ausgangssignale, etwa infolge elektromagnetischer Felder oder der Einwirkung mechanischer Kräfte auf die Übertragungsleitungen, nicht mit Sicherheit auszuschliessen.

### KURZE DARSTELLUNG DER ERFINDUNG

Der Erfindung, wie sie in Patentanspruch 1 definiert ist, liegt die Aufgabe zugrunde, eine Messvorrichtung für eine metallgekapselte, gasisolierte Hochspannungsanlage mit mindestens einem in einem Kapselungsrohr der Metallkapselung angeordneten Sensor anzugeben, welche sich auch in einem starken elektromagnetischen Feldern und unerwarteten mechanischen Belastungen ausgesetzten Umfeld durch eine grosse Messgenauigkeit auszeichnet.

Bei der Messvorrichtung nach der Erfindung ist die von dem mindestens einen Sensor gespeiste elektronische Auswertevorrichtung in einem EMV-Schutz gewährleistenden, zweiteiligen Metallgehäuse angeordnet. Da dieses Gehäuse neben einem trogförmigen Gehäuseelement auch einen Teil der Aussenfläche des Kapselungsrohrs mit einem daran angeformten Hohlflansch aufweist, entfallen störanfällige Übertragungswege für die von dem mindestens einen Sensor abgegebenen Ausgangssignale, und wird so eine gute Genauigkeit der Messvorrichtung erreicht.

Zugleich tragen das Fehlen von Übertragungswegen ausserhalb des Metallgehäuses sowie die EMV-geschützte Anordnung der elektronischen Auswertevorrichtung zu einer wesentlich höheren Betriebssicherheit der Hochspannungsanlage bei, da die Messvorrichtung unabhängig von Umwelteinflüssen Messwerte erarbeitet und - gegebenenfalls formatiert und serialisiert - an eine übergeordnete Leittechnik weiterleitet. Die von der Messvorrichtung abgegebenen Messwerte können zur Lösung unterschiedlicher Aufgaben, wie Steuerung, Messung, Schutz und Energiezählung, eingesetzt werden. Die hierfür bisher benötigte grosse Zahl an Sensoren kann daher ganz erheblich reduziert werden.

### KURZE BESCHREIBUNG DER ZEICHNUNGEN

Bevorzugte Ausführungsbeispiele der Erfindung und die damit erzielbaren weiteren Vorteile werden nachfolgend anhand von Zeichnungen näher erläutert. Hierbei zeigt:
- Fig.1: in axialer Richtung geschnitten eine Ausführungsform einer Messvorrichtung nach der Erfindung mit einem Kapselungsrohr und einem im Rohrinneren angeordneten stromführenden Leiter sowie mit im Rohrinneren angeordneten und als Rogowskispule bzw. isolierte Messelektrode ausgebildeten Sensoren, und mit einem eine elektronische Auswertevorrichtung enthaltenden zweiteiligen Metallgehäuse,
- Fig.2: eine Seitenansicht eines als Federleiste ausgebildeten Teils einer im Metallgehäuse angeordneten Steckvorrichtung zur Verbindung der Ausgänge der Sensoren mit der elektronischen Auswertevorrichtung,
- Fig.3: eine Seitenansicht von rechts auf einen das Metallgehäuse enthaltenden Teil der Messvorrichtung nach den Fig.1,
- Fig.4: eine Untersicht eines als trogförmiges Gehäuseelement ausgeführten Teils des in der Messvorrichtung nach den Fig.1 enthaltenden Metallgehäuses,
- Fig.5: eine Seitenansicht einer in einer Belüftungsöffnung des Gehäuseelementes gemäss Fig.4 angeordneten Belüftungsvorrichtung,
- Fig.6: eine Draufsicht auf einen Spritzwasserschutz der Belüftungsvorrichtung gemäss Fig.5,
- Fig.7: eine Explosionsdarstellung des Spritzwasserschutzes gemäss Fig.6, und
- Fig.8: eine Aufsicht auf einen Schnitt durch eine weitere Ausführungsform einer Belüftungsvorrichtung, deren Spitzwasserschutz gegenüber dem Spritzwasserschutz der Belüftungsvorrichtung gemäss Fig.5 abgeändert ist.

### WEGE ZUR AUSFÜHRUNG DER ERFINDUNG

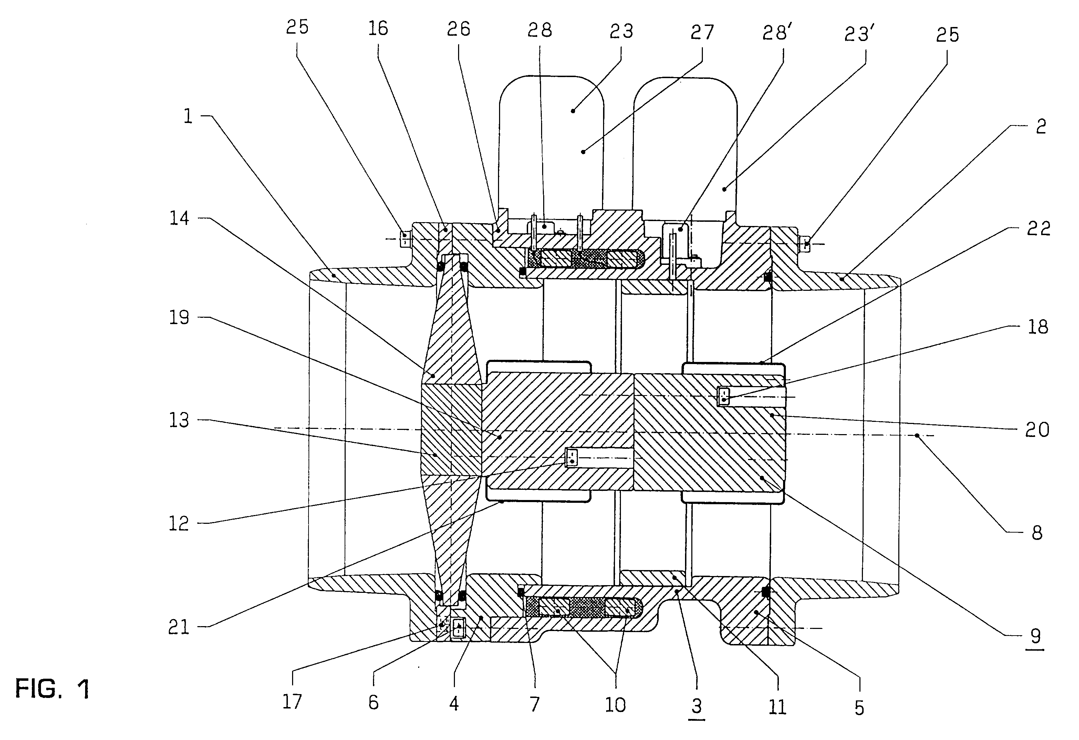

In allen Figuren bezeichnen gleiche Bezugszeichen auch gleichwirkende Teile. Die in Fig.1 dargestellte Messvorrichtung weist ein zwischen zwei Flanschen 1, 2 einer mit einem Isoliergas, wie insbesondere SF₆, von bis zu einigen bar Druck gefüllten Metallkapselung eingespanntes Kapselungsrohr 3 auf. Das Kapselungsrohr 3 ist von zwei jeweils einen Flansch aufweisenden metallenen Rohrabschnitten 4, 5, gebildet, welche mittels Schrauben 6 und eines Dichtungsrings 7 in gasdichter Weise miteinander verspannt sind. Auf der Achse 8 des Kapselungsrohrs 3 ist ein im wesentlichen zylinderförmig ausgebildeter und auf einem Hochspannungspotential von typischerweise mehreren hundert kV befindlicher Stromleiter 9 geführt. In einem von den beiden Rohrabschnitten 4, 5 begrenzten Hohlraum befinden sich zwei Rogowskispulen 10, welche den im Stromleiter 9 geführten Strom detektieren. Auf der dem Stromleiter 9 zugewandten Innenfläche des Kapselungsrohrs ist in einer von den Rohrabschnitten 4 und 5 begrenzten Ringnut eine gegenüber dem Kapselungsrohr 3 elektrisch isoliert angeordnete, die am Stromleiter 9 anliegende Hochspannung erfassende metallene Messelektrode 11 angebracht.

Der Stromleiter 9 ist mit Hilfe von Schrauben 12 starr verbunden mit einer auf der Achse 8 angeordneten Eingussarmatur 13 eines Isolators 14. Die Schrauben 12 sind in Richtung der Achse 8 geführt und sind mit einer Versiegelung (Siegellack) oder einer Plombierung gegen unbefugtes Betätigen geschützt. Ein ringförmiger Aussenrand des Isolators 14 ist mit Hilfe eines axial geführten Halteringes 16 am Flansch des Rohrabschnitts 4 fixiert. Den Haltering 16 am Rohrabschnitt 4 fixierende Schrauben 17 sind mit Hilfe einer Versiegelung oder einer Plombierung ebenfalls gegen unbefugtes Betätigen geschützt.

Der Stromleiter 9 wird ersichtlich von zwei durch axial geführte Schrauben 18 starr miteinander verbundenen Leiterabschnitte 19, 20 gebildet. Hierdurch wird erreicht, dass die den Stromleiter 9 am Isolator 14 fixierenden Schrauben 12 relativ kurz sein können. Die Schrauben 18 sind wie die Schrauben 12 und 17 durch eine Versiegelung oder durch eine Plombierung gegen unbefugtes Betätigen geschützt . Entsprechendes gilt auch für nicht bezeichneten weiteren Schrauben, die der starren Befestigung von Abschirmungen 21, 22 am Stromleiter 9 dienen.

Durch die starre Befestigung des Stromleiters 9 am fest mit dem Kapselungsrohr 3 verbundenen Isolator 14 anstelle der sonst üblichen schwimmenden Lagerung des Stromleiters 9 auf Federkontakten sowie die definierte Halterung der Abschirmungen kann eine definierte Feldgeometrie im Inneren des Kapselungsrohrs 9 eingehalten werden. Dies ist von entscheidender Bedeutung für des Genauigkeit eines von der Messelektrode 11 abgegebenen spannungsproportionalen Signals. Durch die Sicherung der Schrauben 12, 17, 18 sowie der Abschirmungen 21, 22 wird erreicht, dass nach der Fertigstellung des hochspannungsbelasteten Teils der Messvorrichtung deren Feldgeometrie nicht verändert wird. Die in der Messvorrichtung enthaltenen Sensoren, wie die Rogowskispulen 10, die Messelektrode 11 sowie weitere gegebenenfalls vorhandene Sensoren, wie etwa Temperatur-, Druck- und Dichtefühler, Teilentladungssensoren und Lichtbogenwächter, können nun geeicht werden und die hierbei ermittelten Eichwerte sowie weitere Kenngrössen, wie Kompensationskurven, die beispielsweise temperaturbedingte Messabweichungen erfassen, in einem nicht überschreibbaren Datenspeicher (beispielsweise einem PROM) einer ausserhalb des isoliergasgefüllten Innenraums des Kapselungsrohrs 3 angeordneten elektronischen Auswertevorrichtung 23 der Messvorrichtung gespeichert werden. Dieser Datenspeicher kann durch Plombierung oder Versiegelung ebenfalls gegen unbefugtes Betätigen geschützt werden und ist lediglich der Elektronik der Auswertevorrichtung 23 zugänglich. Weist die Elektronik der Auswertevorrichtung 23 Mängel auf, so kann nach deren Austausch die neu in die Auswertevorrichtung eingesetzte Elektronik direkt auf die im PROM abgelegten Daten zugreifen. Kalibrierarbeiten beim Auswechseln der Elektronik können daher entfallen.

Die Messvorrichtung gemäss Fig.1 kann durch Verspannen des Flansches 1 und des Rohrabschnitts 4 sowie des Flansches 2 und des Rohrabschnitts 5 mit Hilfe von Spannschrauben 25 gasdicht (aus den Figuren ersichtliche nicht bezeichnete Dichtungsringe) in die Metallkapselung eingebaut werden.

Die Ausgänge der Rogowskispulen 10 und der Messelektrode 11 sind über abgeschirmte Messkabel und Gehäusedurchführungen, von denen die Gehäusedurchführung für das mit der Messelektrode 11 verbundene Messkabel gasdicht ausgeführt ist, an die in einem zweiteiligen Metallgehäuse untergebrachte Auswertevorrichtung 23 geführt. Eine weitere Auswertevorrichtung 23' kann in einem weiteren Metallgehäuse vorgesehen sein. Die Auswertevorrichtung 23 kann überwiegend zur Verarbeitung der Ausgangssignale der Rogowskispulen 10, die Auswertevorrichtung 23' überwiegend zur Verarbeitung der Ausgangssignale der Messelektrode 11 bestimmt sein. Die Ausgangssignale der Rogowskispulen 10 können aber auch in die Auswertevorrichtung 23' und umgekehrt die Ausgangssignale der Messelektrode 11 in die Auswertevorrichtung 23 geführt werden. Die Auswertevorrichtung 23 kann auch die Aufgaben der Auswertevorrichtung 23' und die Auswertevorrichtung 23' die Aufgaben der Auswertevorrichtung 23 übernehmen. Beide Auswertevorrichtung 23 und 23' können auch synchron zusammenwirken. Eine solche Messvorrichtung weist eine besonders grosse Redundanz auf, da beim Ausfall einer der beiden Auswertevorrichtungen die noch betriebsbereite Auswertevorrichtung die weitere Verarbeitung der Sensorausgangssignale durchführen kann.

Das eine Teil des Metallgehäuses ist jeweils von einem an die Aussenfläche des Kapselungsrohrs 3 angeformten metallenen Hohlflansch 26 und dem vom Hohlflansch umrandeten Bereich des Kapselungsrohrs 3 gebildet. Das andere Teil ist ein trogförmig vertieftes Gehäuseelement 27, welches mit seinem die Trogöffnung begrenzenden Rand am metallenen Hohlflansch 26 des Kapselungsrohrs 3 befestigt ist. In diesem Metallgehäuse ist die Auswertevorrichtung 23 vor elektromagnetischen und mechanischen Einwirkungen geschützt untergebracht. Da so lange Übertragungswege zwischen den Sensoren und der Auswertevorrichtung 23 und daraus resultierende Störungen entfallen, können die Verarbeitungsgeschwindigkeit und die Messgenauigkeit beträchtlich gesteigert werden.

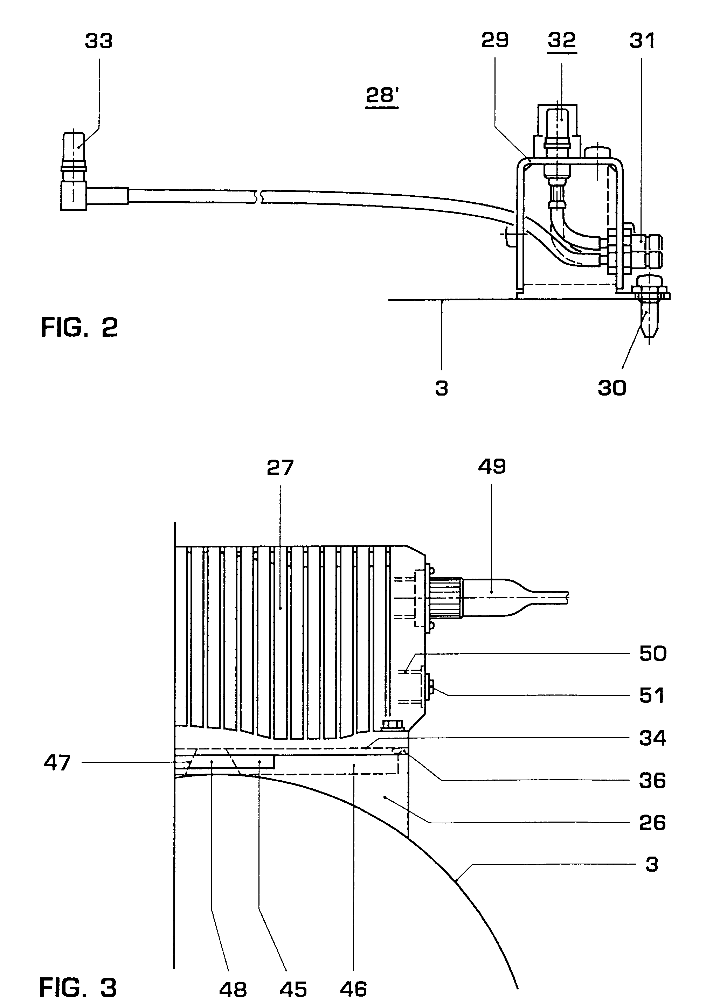

Die die Ausgangssignale der Sensoren in das Metallgehäuse führenden abgeschirmten Messkabel sind an eine in Inneren des Metallgehäuses angeordnete Steckvorrichtung 28 bzw. 28' geführt. Die Steckvorrichtung 28 bzw. 28' weist ein in einer quer zur Steckrichtung erstreckten ebenen Auflagefläche des umrandeten Bereichs des Kapselungsrohrs 3 schwimmend gelagertes Steckteil auf. Dieses Steckteil ist in Fig.2 für die Steckvorrichtung 28' dargestellt. Es weist eine gewinkelt ausgebildete und ein Z-winkelförmiges Profil enthaltende Federleiste 29 auf. Ein in der ebenen Auflagefläche geführter unterer Schenkel des Z-Winkels ist mittels am Kapselungsrohr gehaltener Schrauben 30 schwimmend gelagert. Ein L-förmig angesetzter mittlerer Schenkel des Z trägt ein mit einem Steckkontakt des Messkabels elektrisch leitend verbindbares Kupplungsstück 31. Der an den mittleren Schenkel angesetzte obere Schenkel des Z trägt ein mit dem Kupplungsstück 31 verbundenes Kupplungsstück 32, welches mit einem aus Fig.3 ersichtlichen Stecker 45 der Auswertevorrichtung 23 zusammenwirkt. Ein Steckkontakt des Kupplungstücks 31 kann über ein langes Leiterstück mit einem Steckkontakt 33 verbunden sein, welcher im benachbarten Metallgehäuse mit einem auf der Federleiste der Steckvorrichtung 28 angeordneten Kupplungsstück zusammenwirkt.

Alternativ kann der mittlere Schenkel des Z relativ kurz ausgebildet sein. Das Kupplungstück 31 kann dann an der Unterseite des oberen Schenkels des Z angebracht und direkt mit dem Kupplungstück 32 verbunden sein.

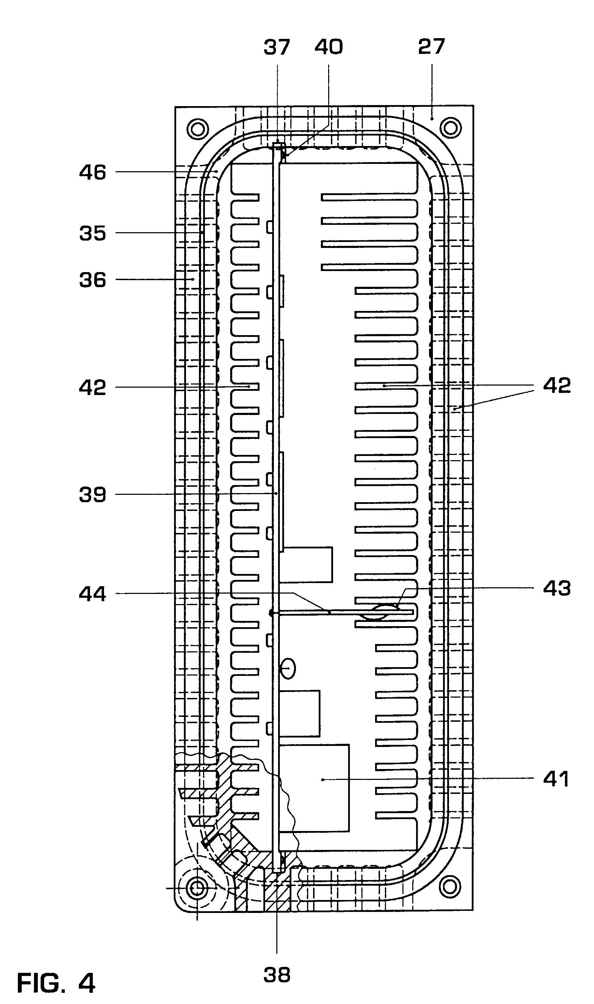

Aus den Figuren 3 und 4 sind der Aufbau und die Anordnung des die Auswertevorrichtung 23 bzw. 23' enthaltenden Metallgehäuses ersichtlich. Der Hohlflansch 26 weist eine um die Flanschöffnung geführte ebene Kontaktfläche 34 (Fig.3) auf, welche mit einer um die Trogöffnung geführten ebenen Kontaktfläche 35 des Trogrands (Fig.4) unter Bildung einer galvanischen Verbindung zusammenwirkt. Die beiden im wesentlichen vom Hohlflansch 26 und dem Gehäuseelement 27 gebildeten Teile des Metallgehäuses sind so miteinander elektrisch leitend verbunden und bilden einen Faradaykäfig für die Auswertevorrichtung. Die beiden ringförmig geschlossenen Kontaktflächen sind von mindestens einem zwischen dem Hohlflansch 26 und dem Trogrand eingespannten O-Ring 36 umgeben. Hierdurch wird eine praktisch gasdichte Verbindung der beiden Gehäuseteile erreicht und werden zugleich die beiden Kontaktflächen 34 und 35 vor von aussen zutretenden Schadstoffen geschützt.

Auf einander gegenüberstehenden Innenflächen des Gehäuseelementes 27 ist jeweils mindestens eine sich vom Trogrand in Richtung des Trogbodens erstreckende Nut 37 bzw. 38 eingeformt (Fig.4). Diese Nut dient der Aufnahme einer Kante einer mit einem oder mehreren Steckkontakten der Steckvorrichtung 28 bzw. 28' elektrisch leitend verbindbaren Printplatte 39 der Auswertevorrichtung. Die Nut 37 bzw. 38 ist mit Übermass ausgeführt und nimmt zusätzlich am Rand der Printplatte 39 angebrachte Kontaktfedern 40 auf. Mit den Kontaktfedern verbundene Leiterbahnen der Printplatte 39 werden so auf das Potential des Metallgehäuses geführt. Auf der Printplatte 39 befindliche elektronische Komponenten mit einer mit den Kontaktfedern 40 galvanisch verbundenen Umhüllung 41 werden so elektromagnetisch abgeschirmt.

In das trogförmige Gehäuseelement 27 sind innen und/oder aussen Kühlrippen 42 eingeformt. Die inneren Kühlrippen nehmen von den elektronischen Komponenten gebildete Wärme auf. Diese Wärme wird nach aussen geleitet und von den äusseren Kühlrippen an die Umgebung abgegeben.

Die inneren Kühlrippen können zusätzliche Aufgaben erfüllen. Wie aus Fig.4 ersichtlich ist, können zwischen zwei benachbart angeordneten Kühlrippen 42 ein Rand und Kontaktfedern 43 einer plattenförmig ausgebildeten und zwischen zwei elektronischen Komponenten angeordneten elektromagnetischen Abschirmung 44 der Auswertevorrichtung angeordnet sein. Diese Abschimung 44 wirkt als elektromagnetische Barriere zwischen den benachbarten elektronischen Komponenten.

Die Trogöffnung ist abgeschlossen mit einer elektromagnetisch schirmenden Deckplatte sowie mit dem durch eine Öffnung der Deckplatte geführten Stecker 45, welcher mit dem Kupplungsstück 32 zusammenwirkende Steckkontakte trägt. Das Gehäuseelement 27 weist einen den Trogrand überragenden und durch die Flanschöffnung des Hohlflansch 26 geführten Kragen 46 auf. Der Kragen 46 steht zudem über den Stecker 45 vor und weist eine mit einer Auskragung 47 des Hohlflansches 26 zusammenwirkende Materialaussparung 48 auf (Fig.3).

Der Kragen 46 erfüllt folgende Funktionen: Bei der Montage der Messvorrichtung führt er das Gehäuseelement 27 in den Hohlflansch 26. Hierbei stellt die als Kodierung mit der Materialaussparung 48 zusammenwirkende Auskragung 47 sicher, dass das Gehäuseelement 27 und damit der Stecker 45 in der richtigen Lage in das Kupplungsstück 32 eingeführt wird. Es wird so ausgeschlossen, dass das Ausgangssignal etwa einer der Rogowskispulen 11 durch eine falsche Steckverbindung an eine zu dessen Verarbeitung ungeeignete Elektronikkomponente der Auswertevorrichtung geführt wird. Da der Kragen 46 über den Stecker 45 vorsteht, kann beim Zusammenbau der Stecker 45 nicht mit einem Teil des Hohlflansches in Berührung kommen und hierbei beschädigt werden.

Beim Zusammenbau ist es von Vorteil, dass die Federleiste 29 schwimmend gelagert ist. Nicht zu vermeidende Lageabweichungen des Kupplungsstücks 32 und des Steckers 45 können so in besondes einfacher Weise kompensiert werden.

Wie aus Fig.3 ersichtlich ist, ist am Gehäuseelement 27 ein Stecker 49 angebracht, welcher mit einem durch die Wand des Gehäuseelement 27 geführten und mit der Auswertevorrichtung 23 bzw. 23' verbundenen Kupplungsstück zusammenwirkt. Durch die so gebildete Steckverbindung kommuniziert die Auswertevorrichtung 23 bzw. 23' vorzugsweise über störfreie Lichtwellenleiter mit einer übergeordneten Leittechnik und wird die Auswertevorrichtung 23 bzw. 23' über eine Drahtverbindung gleichzeitig mit elektrischer Energie versorgt. Die Kommunikation umfasst vor allem die Übermittlung digitalisierter Messwerte, etwa des Stromes, der Spannung, der Temperatur, des Drucks oder der Dichte, an die Leittechnik, kann aber auch der Übermittlung von in der Leittechnik gebildeter Information an die Auswerteeinheit 23 bzw. 23' dienen.

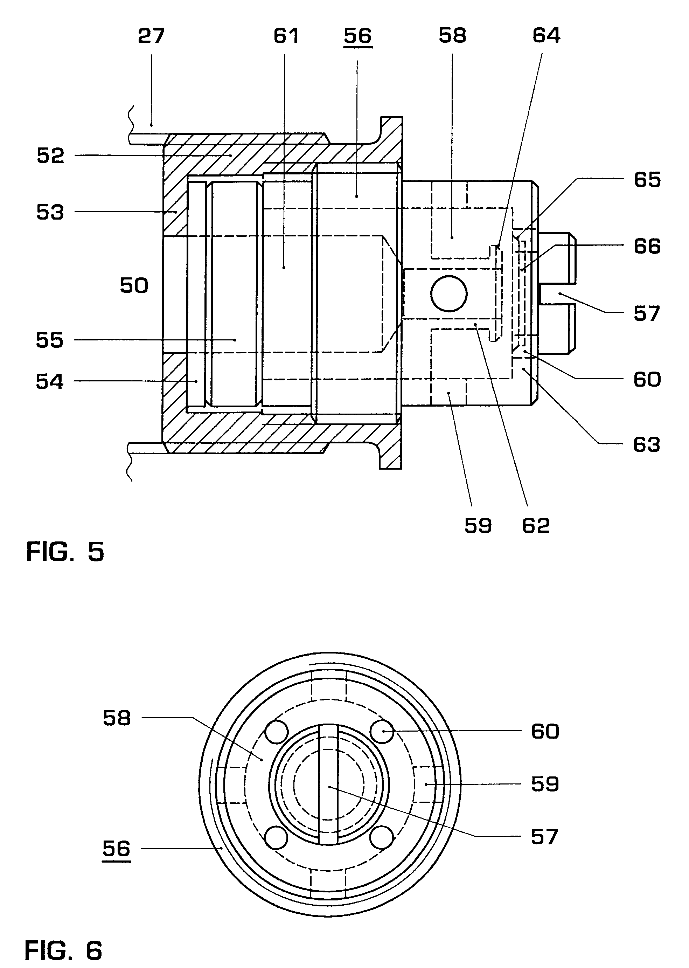

Durch die Wand des Gehäuseelements 27 ist auch eine Belüftungsöffnung 50 geführt, in die eine bolzenförmig ausgebildete Belüftungsvorrichtung 51 eingeschraubt ist. Wie aus Fig.5 ersichtlich ist, weist diese Belüftungsvorrichtung eine mit einem Aussengewinde versehene und durch Einschrauben in der Belüftungsöffnung 50 fixierbare Buchse 52 auf. Die Buchse 52 ist an der nach aussen weisenden Stirnseite offen. Die dem Inneren des von Hohlflansch 26 und Gehäuseelement 27 gebildeten Metallgehäuses zugewandte Stirnseite der Buchse 52 wird von einer an die hohlzylinderförmige Buchsenwand angesetzten Wand 53 mit einer zentral angeordneten Öffnung gebildet. Im Inneren der Buchse 52 sind ein auf der Wand 53 abgestützter Dichtungsring 54, eine auf dem Dichtungsring aufliegende Membran 55 und ein zylinderförmiger Bolzen 56 angeordnet. Der Bolzen 56 weist auf seiner Mantelfläche ein mit einem Innengewinde der Buchse 52 zusammenwirkendes Aussengewinde und an seiner ausserhalb der Belüftungsöffnung 50 liegenden Stirnfläche einen radial geführten Schlitz 57 für einen Schraubendreher auf. Durch Einschrauben des Bolzens 56 wird die Membran 55 gegen den auf der Wand 53 abgestützten Dichtungsring 54 gepresst und wird so eine gasdichte Lagerung der Membran 55 in der Buchse 52 erreicht.

Die Membran 55 wirkt wie ein luftlässiges, staubabscheidendes und für Wasser richtungsabhängig wirkendes Wasserdampfventil, welches im Gehäuseinneren vorhandenen oder dort gebildeten Wasserdampf nach aussen, nicht aber Wasserdampf von aussen ins Gehäuseinnere führt. Kondenswasserbildung im Gehäuseinneren und damit eine Beeinträchtigung der Funktionsfähigkeit der Auswertevorrichtung 23 bzw. 23' werden so vermieden. Zugleich verhindert die Membran 55 den Zutritt von Staub ins Gehäuseinnere. Diesem Wasserdampfventil vorgeschaltet ist ein vom Bolzen 56 gebildeter Spritzwasserschutz. Dieser Spritzwasserschutz enthält ein den Zutritt von Spritzwasser an die Membran 55 verhinderndes und den Austritt von eingedrungem Spritzwasser ermöglichendes Labyrinth von Kanälen.

In den Figuren 5 bis 7 ist das Labyrinth gestrichelt dargestellt. Es weist eine im Bolzeninneren angeordnete Vorkammer 58 auf. Diese Vorkammer 58 ist ringförmig ausgebildet und kommuniziert über acht Öffnungen 59 und 60 mit dem Aussenraum. Von diesen acht Öffnungen sind vier gegeneinander um 90° versetzt angeordnete Öffnungen 59 radial und vier gegeneinander ebenfalls um 90° versetzt angeordnete Öffnungen 60 axial nach aussen geführt. Das Labyrinth weist ferner eine im Bolzen 56 in axialer Richtung erstreckte und an die Membran 55 geführte Hauptkammer 61 auf. Diese Hauptkammer 61 ist über mindestens eine Schikane mit der vorkammer 58 verbunden.

Zur Verbindung der Haupt- 61 und der Vorkammer 58 ist ein von einem pilzförmig ausgebildeten, axial ausgerichteten hohlen Zapfen 62 und einer im wesentlichen quer zum Zapfen 62 ausgerichteten Wand 63 begrenzter Kanal vorgesehen. Der der Wand 63 zugewandte Rand 64 des Pilzhutes und ein gegenüberliegender Rand 65 einer in die Wand eingelassenen, kreisförmigen Nut 66 sind unter Bildung eines hohlkegelstumpfförmigen Ringkanals abgeschrägt ausgeführt.

Die in der Wand 63 vorgesehenen vier axial geführten Öffnungen 60 sind derart angeordnet, dass eintretendes Spritzwasser lediglich in die Vorkammer 58 oder allenfalls auf den abgeschrägten Rand 64 des Pilzhutes trifft. Die radial geführten Öffnungen 59 sind derart in der Mantelfläche des Bolzens 56 angeordnet, dass eintretendes Spritzwasser lediglich auf den Pilzfuss triffen kann. Eintretendes Spritzwasser kann daher nicht in die Hauptkammer 61 gelangen und wird in jeder Lage der Belüftungsvorrichtung 51 und damit auch des Metallgehäuses über mindestens eine der Öffnungen 59 und 60 wieder aus der Vorkammer 58 entfernt. Eine Ablagerung von Wasser auf der Membran 55 kann so mit grosser Sicherheit erfolgreich vermieden werden. Durch abgelagertes - gegebenenfalls gefrierendes - Wasser, könnte sonst die Membran 55 verstopft werden. Im Gehäuseinneren gebildeter Wasserdampf könnte dann nicht mehr durch die Ventilwirkung aufweisende Membran 55 in die Hauptkammer 61 und von dort in den Aussenraum geführt werden.

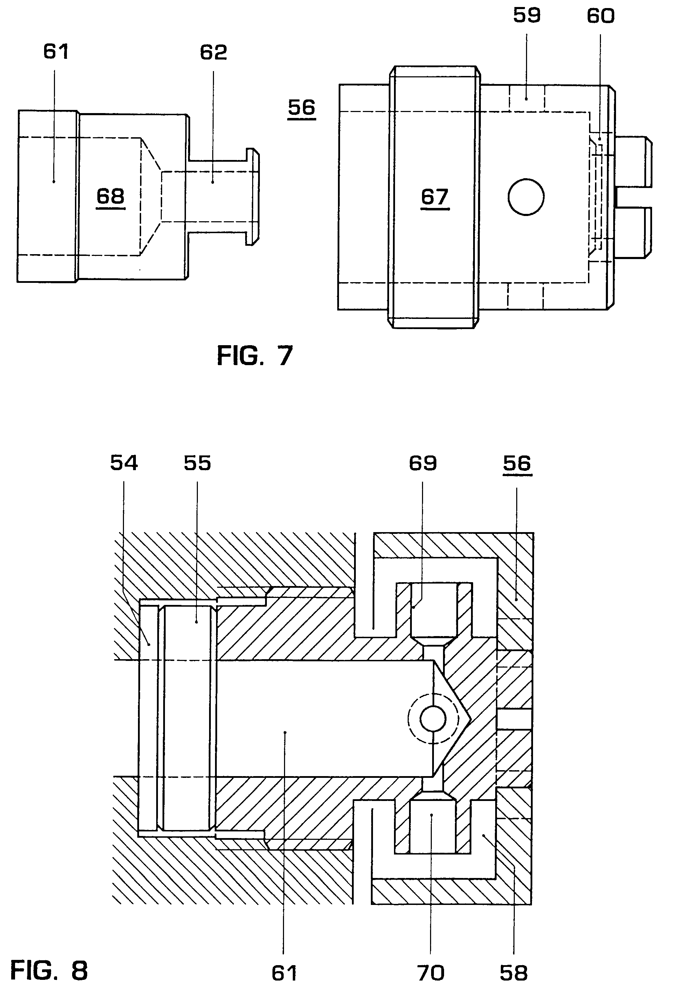

Wie aus Fig.7 ersichtlich ist, besteht der Bolzen 56 aus einem die Öffnungen 59 und 60 enthaltenden topfförmigen Grundkörper 67 und einem den Zapfen 62 und die Hauptkammer 61 enthaltenden, flaschenförmigen Hohlkörper 68. Durch Einpressen des Hohlkörpers 68 in den Grundkörper 67 kann so in besonders einfacher Weise der das Labyrinth enthaltende Bolzen 56 hergestellt werden.

Eine alternative Ausführungsform des Bolzens ist aus Fig.8 ersichtlich. Bei dieser Ausführungsform sind zur Verbindung der Haupt- 61 und der Vorkammer 58 mehrere in Umfangsrichtung verteilt angeordnete, radial geführte und mit jeweils einem überkragenden Rohrabschnitt 69 in die Vorkammer 58 einmündende Kanäle 70 vorgesehen.

### Bezugszeichenliste

- 1, 2: Flansche
- 3: Kapselungsrohr
- 4, 5: Rohrabschnitte
- 6: Schrauben
- 7: Dichtungsring
- 8: Achse
- 9: Stromleiter
- 10: Rogowskispulen
- 11: Messelektrode
- 12: Schrauben
- 13: Eingussarmatur
- 14: Isolator
- 15: Tragring
- 16: Haltering
- 17, 18: Schrauben
- 19, 20: Leiterabschnitte
- 21, 22: Abschirmungen
- 23, 23': Auswertevorrichtungen
- 25: Schrauben
- 26: Hohlflansch
- 27: Gehäuseelement
- 28, 28': Steckvorrichtungen
- 29: Federleiste
- 30: Schrauben
- 31, 32: Kupplungsstücke
- 33: Steckkontakte
- 34, 35: Kontaktflächen
- 36: O-Ring
- 37, 38: Nuten
- 39: Printplatte
- 40: Kontaktfedern
- 41: Abschirmung
- 42: Kühlrippen
- 43: Kontaktfedern
- 44: Abschirmung
- 45: Stecker
- 46: Kragen
- 47: Auskragung
- 48: Materialaussparung
- 49: Stecker
- 50: Belüftungsöffnung
- 51: Belüftungsvorrichtung
- 52: Buchse
- 53: Wand
- 54: Dichtungsring
- 55: Membran
- 56: Bolzen
- 57: Schlitz
- 58: Vorkammer
- 59, 60: Öffnungen
- 61: Hauptkammer
- 62: Zapfen
- 63: Wand
- 64, 65: Ränder
- 66: Nut
- 67: Grundkörper
- 68: Hohlkörper
- 69: Rohrabschnitt
- 70: Kanäle

## Patentansprüche

1. Messvorrichtung für eine metallgekapselte, gasisolierte Hochspannungsanlage mit mindestens einem in einem isoliergasgefüllten Kapselungsrohr (3) der Metallkapselung angeordneten Sensor (10, 11) und mindestens einer Ausgangssignale des mindestens einen Sensors (10, 11) verarbeitenden elektronischen Auswertevorrichtung (23, 23'), dadurch gekennzeichnet, dass die mindestens eine Auswertevorrichtung (23, 23') und eine die Auswertevorrichtung mit einem Ausgang des mindestens einen Sensors (10, 11) verbindende Steckvorrichtung (28, 28') in einem zweiteiligen Metallgehäuse angeordnet sind, dessen eines Teil von einem an die Aussenfläche des Kapselungsrohrs (3) angeformten metallenen Hohlflansch (26) und dem vom Hohlflansch (26) umrandeten Bereich des Kapselungsrohrs (3) gebildet ist, und dessen anderes Teil ein trogförmig vertieftes Gehäuseelement (27) ist, welches mit seinem die Trogöffnung begrenzenden Rand am metallenen Hohlflansch (26) des Kapselungsrohrs (3) befestigt ist.

2. Messvorrichtung nach Anspruch 1, dadurch gekennzeichnet, dass der Hohlflansch (26) eine um die Flanschöffnung geführte ebene Kontaktfläche (34) aufweist, welche mit einer um die Trogöffnung geführten ebenen Kontaktfläche (35) des Trogrands unter Bildung einer galvanischen Verbindung zusammenwirkt.

3. Messvorrichtung nach Anspruch 2, dadurch gekennzeichnet, dass die Kontaktflächen (34, 35) von mindestens einem zwischen dem Hohlflansch (26) und dem Trogrand eingespannten O-Ring (36) umgeben sind.

4. Messvorrichtung nach einem der Ansprüche 1 bis 3, dadurch gekennzeichnet, dass in das trogförmige Gehäuseelement (27) Kühlrippen (42) eingeformt sind.

5. Messvorrichtung nach Anspruch 4, dadurch gekennzeichnet, dass in einer Führung, welche im Inneren des Gehäuseelementes (27) vorgesehen und von zwei benachbart angeordneten Kühlrippen (42) gebildet ist, ein Rand und Kontaktfedern (43) einer plattenförmig ausgebildeten und zwischen zwei elektronischen Komponenten angeordneten elektromagnetischen Abschirmung (44) der Auswertevorrichtung (23, 23') angeordnet sind.

6. Messvorrichtung nach einem der Ansprüche 1 bis 5, dadurch gekennzeichnet, dass auf einander gegenüberstehenden Innenflächen des Gehäuseelementes (27) jeweils mindestens eine sich vom Trogrand in Richtung des Trogbodens erstreckende Nut (37, 38) eingeformt ist, welche der Aufnahme einer Kante einer mit einem Stecker (45) der Steckvorrichtung (28, 28') elektrisch leitend verbundenen Printplatte (39) der Auswertevorrichtung dient.

7. Messvorrichtung nach Anspruch 6, dadurch gekennzeichnet, dass die Nut (37, 38) mit Übermass ausgeführt ist und zusätzlich am Rand der Printplatte (39) angebrachte Kontaktfedern (40) aufnimmt.

8. Messvorrichtung nach Anspruch 7, dadurch gekennzeichnet, dass mindestens eine auf der Printplatte (39) befindliche elektronische Komponente mit einer mit den Kontaktfedern (40) galvanisch verbundenen Umhüllung (41) elektromagnetisch abgeschirmt ist.

9. Messvorrichtung nach einem der Ansprüche 6 bis 8, dadurch gekennzeichnet, dass die Trogöffnung abgeschlossen ist mit einer elektromagnetisch schirmenden Deckplatte sowie mit dem durch eine Öffnung der Deckplatte geführten Stecker (45).

10. Messvorrichtung nach einem der Ansprüche 6 bis 9, dadurch gekennzeichnet, dass das Gehäuseelement (27) einen den Trogrand überragenden und durch die Öffnung des Hohlflansches (26) geführten Kragen (46) aufweist.

11. Messvorrichtung nach Anspruch 10, dadurch gekennzeichnet, dass der Kragen (46) eine mit einer Auskragung (47) des Hohlflansches (26) zusammenwirkende Materialaussparung (48) aufweist.

12. Messvorrichtung nach einem der Ansprüche 10 oder 11, dadurch gekennzeichnet, dass der Kragen (46) über den Stecker (45) vorsteht.

13. Messvorrichtung nach einem der Ansprüche 6 bis 12, dadurch gekennzeichnet, dass ein vom Stecker (45) kontaktiertes Kupplungsstück (32) der Steckvorrichtung (28, 28') auf einer profiliert ausgebildeten Federleiste (29) angeordnet ist, welche auf einer quer zur Steckrichtung erstreckten ebenen Auflagefläche des umrandeten Bereichs des Kapselungsrohrs (3) schwimmend gelagert ist.

14. Messvorrichtung nach Anspruch 13, dadurch gekennzeichnet, dass das Profil der Federleiste (29) einen Z-Winkel enthält, dessen unter Schenkel mittels am Kapselungsrohr (3) gehaltener Schrauben (30) schwimmend gelagert ist, und dessen oberer Schenkel das erste Kupplungsstück (32) trägt.

15. Messvorrichtung nach einem der Ansprüche 1 bis 14, dadurch gekennzeichnet, dass das Metallgehäuse mindestens eine vorzugsweise durch eine Wand des trogförmigen Gehäuseelementes (27) geführte Belüftungsöffnung (50) aufweist.

16. Messvorrichtung nach Anspruch 15, dadurch gekennzeichnet, dass in der Belüftungsöffnung (50) eine Belüftungsvorrichtung (51) angeordnet ist mit einem luftdurchlässigen, richtungsabhängig wirkenden Wasserdampfventil und einem dem Wasserdampfventil vorgeschalteten Spritzwasserschutz.

17. Messvorrichtung nach Anspruch 16, dadurch gekennzeichnet, dass das Wasserdampfventil mindestens eine Wasserdampf aus dem Gehäuseinneren nach aussen, nicht aber Wasserdampf von aussen ins Gehäuseinnere führende Membran (55) enthält, und dass der Spritzwasserschutz ein den Zutritt von Spitzwasser an die Membran (55) verhinderndes, den Austritt von eingedrungem Spritzwasser ermöglichendes Labyrinth von Kanälen enthält.

18. Messvorrichtung nach Anspruch 17, dadurch gekennzeichnet, dass das Labyrinth in einem die Membran (55) in gasdichter Weise fixierenden zylinderförmigen Bolzen (56) angeordnet ist.

19. Messvorrichtung nach Anspruch 18, dadurch gekennzeichnet, dass der Bolzen (56) eine ringförmig ausgebildete und über mehrere Wandöffnungen (59, 60) nach aussen geführte Vorkammer (58) enthält sowie eine in axialer Richtung erstreckte und an die Membran (55) geführte Hauptkammer (61), welche über mindestens eine Schikane mit der Vorkammer (58) verbunden ist.

20. Messvorrichtung nach Anspruch 19, dadurch gekennzeichnet, dass zur Verbindung der Haupt- (61) und der Vorkammer (58) mehrere in Umfangsrichtung verteilt angeordnete, radial geführte und mit jeweils einem überkragenden Rohrabschnitt (69) in die Vorkammer (58) einmündende Kanäle (70) vorgesehen sind.

21. Messvorrichtung nach Anspruch 19, dadurch gekennzeichnet, dass zur Verbindung der Haupt- (61) und der Vorkammer (58) ein von einem pilzförmig ausgebildeten, axial ausgerichteten hohlen Zapfen (62) und einer im wesentlichen quer zum Zapfen (62) ausgerichteten Wand (63) begrenzter Kanal vorgesehen ist.

22. Messvorrichtung nach Anspruch 21, dadurch gekennzeichnet, dass der der Wand (63) zugewandte Rand (64) des Pilzhutes und ein gegenüberliegender Rand (65) einer in die Wand (63) eingelassenen, kreisförmigen Nut (66) unter Bildung eines hohlkegelstumpfförmigen Ringkanals abgeschrägt ausgeführt sind.

23. Messvorrichtung nach Anspruch 22, dadurch gekennzeichnet, dass ein erster Teil der die Vorkammer (58) nach aussen führenden Öffnungen (60) derart in der Wand (63) angeordnet ist, dass eintretendes Spritzwasser lediglich in die Vorkammer (58) oder allenfalls auf den abgeschrägten Rand (64) des Pilzhutes gelangt.

24. Messvorrichtung nach Anspruch 23, dadurch gekennzeichnet, dass ein zweiter Teil der die Vorkammer (58) nach aussen führenden Öffnungen (59) derart in der Mantelfläche des Bolzens (56) angeordnet ist, dass eintretendes Spritzwasser lediglich auf den Pilzfuss gelangt.

25. Messvorrichtung nach einem der Ansprüche 21 bis 24, dadurch gekennzeichnet, dass der Zapfen (62) in einen die Wand (63) enthaltenden topfförmigen Grundkörper (67) des Bolzens (56) eingepresst ist.

26. Messvorrichtung nach einem der Ansprüche 1 bis 25, bei der der mindestens eine Sensor (10, 11) zur Erfassung des Stromes eines durch das Kapselungsrohr (3) geführten stromführenden Leiters (9) als Rogowskispule (10) ausgebildet ist, und bei der neben der Rogowskispule (10) zur Erfassung der Spannung des Leiters als weiterer Sensor (10, 11) eine den Leiter (9) umgebende Messelektrode (11) sowie gegebenenfalls unter anderem auch auch Druck-, Temperatur-, Dichte- und/oder Teilentladungssensoren vorgesehen sind, dadurch gekennzeichnet, dass Kenngrössen und Kalibrierdaten der Sensoren (10, 11) in einem von der Auswertevorrichtung (23, 23') abrufbaren, nicht überschreibbaren Datenspeicher abgelegt sind.

27. Messvorrichtung nach Anspruch 26, dadurch gekennzeichnet, dass der Datenspeicher gegen unbefugtes Betätigen geschützt im Inneren des Metallgehäuses angeordnet ist.

28. Messvorrichtung nach einem der Ansprüche 1 bis 27, dadurch gekennzeichnet, dass neben der mindestens einen Auswertevorrichtung (23) mindestens eine weitere Auswertevorrichtung (23') vorgesehen ist, welche bei Ausfall der mindestens einen Auswertevorrichtung (23) deren Aufgaben übernimmt.
